# EUROPEAN PATENT APPLICATION

(11) **EP 0 582 752 A1**
(43) Date of publication of application: **16.02.1994**
(21) Application number: 92202464.1
(22) Date of filing: 11.08.1992
(51) Int. Cl.: G03F 7/30

(54) **Photographic development apparatus and a method relating thereto**

(71) Applicant: AGFA-GEVAERT naamloze vennootschap, B-2640 Mortsel (BE)
(72) Inventor: Claes, Jan, Agfa-Gevaert NN.V., B-2640 Mortsel (BE); Jacobs, Robert, c/o Agfa-Gevaert NN.V., B-2640 Mortsel (BE)

(57) **Abstract**

An apparatus 10 for processing photographic material having a liquid reservoir 16 and a pump 33 for delivering liquid to the reservoir. The pump is calibrated by using a level sensor 25 for determining when the liquid in the reservoir has reached a predetermined level, timer means 36 for measuring the time period needed to fill said reservoir to said predetermined level, and processor means 36 which calculates the pump flow rate and stores aid measured information as a standard reference and uses the information to control the operation of the pump for further delivery of liquid to the reservoir.

## Description

### BACKGROUND OF THE INVENTION

### Field of the invention.

This invention relates to apparatus for the development of exposed photographic material, and in particular to apparatus for developing lithographic offset printing plates, and to a method of calibrating pumps for the replenishment of processing liquid for such apparatus.

### Description of the prior art.

In an apparatus or system for the development of aluminium lithographic printing plates of the type disclosed in EP 410500 it is advantageous to maintain the strength of the processing liquids within specified limits so as to maintain high quality printing plates, and reduce waste products.

This can be achieved by constantly topping up a process liquid reservoir as photographic material is processed.

The volume of liquid to be added to regenerate a reservoir is related to the amount of sheet material processed. However, there are a large number of parameters which can influence the actual volume of liquid which is added to the liquid reservoir when compared with the required volume of liquid, these include initial manual calibration tolerances, and the pump operating conditions for example, line voltage, alternating current frequences, aging, height of liquid lift, pump heating during operation.

### Object of invention.

The object of the invention is to provide an apparatus which is capable of accurate regeneration, and a method of calibrating the apparatus for regeneration.

### Statement of invention.

This invention relates to apparatus for processing photographic material and which includes at least one liquid reservoir which in use is filled with liquid, a pump for delivering liquid to the reservoir, a level sensor for determining when the liquid in the reservoir has reached a predetermined level, timer means which measures the time period needed to fill said reservoir to said predetermined level, processor means which calibrates the pump flow rate from the measured time period and stores said measured information as a standard reference and uses the information to control the operation of the pump for further delivery of liquid to the reservoir.

Also according to the invention there is provided a method of calibrating the delivery of liquid by a pump into a reservoir of a photographic development apparatus, said method comprising measuring the time taken to fill the reservoir through the pump to a predetermined level under standard conditions, storing said information or information derived therefrom ina memory, and using said information or information derived therefrom as a reference standard for subsequent controlled operations of the pump.

The calibration assures that all effects of the pump and its circuit are compensated for.

Conveniently, on refilling an empty reservoir on an apparatus whose pump is calibrated by the above method, the time taken to refill the reservoir is taken and that information or information derived therefrom is compared with the reference standard and if the difference between the new information and the reference standard falls within a predetermined difference band than the newly measured information is substituted for the previous standard for subsequent operation of the pump, and preferably if the difference falls outside of said band an alarm means is activated.

### Brief description of drawings.

The invention will be described by way of example and with reference to the accompanying drawings in which :

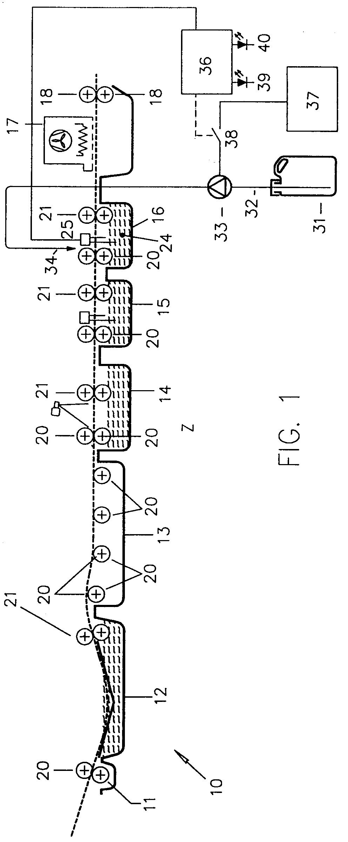

Fig. 1 is a schematic layout of one embodiment of a processing apparatus according to the invention.

### Detailed description of the invention.

With reference to Fig. 1 there is illustrated a longitudinal cross-section through an apparatus 10 for processing exposed photographic sheet material, in particular aluminium lithographic printing plates, of the type described in EP-A-410500.

EP-A-410500 disclosed an imaging element containing an aluminium support provided with in the order given an image receiving layer containing a silver halide emulsion. In the document there is disclosed a diffusion transfer reversal process (hereinafter called DTR-process) for obtaining a lithographic printing plate in which said imaging element is image-wise exposed and subsequently developed using a developing liquid or activating liquid in the presence of a silver halide complexing agent. The imaging element is then guided through a diffusion transfer zone so that the silver halide complexes formed during the development step are allowed to diffuse into the image-receiving layer where they are converted to silver. When the imaging element leaves the diffusion transfer zone a silver image is formed in the image receiving layer. The now useless photosensitive layer and optional other layers above the image receiving layer are then removed by rinsing the imaging element in a washing section. Finally the element now carrying a silver image on its surface is treated with a finishing liquid that contains a so called hydrophobizing agent for improving the hydrophobicity of the silver image.

In the above described method for obtaining an aluminium based lithographic printing plate according to the DTR-process at least 3 different liquids are used i.e. a developing or activating liquid, a rinsing liquid and a finishing liquid.

The apparatus 10 is mounted within a generally rectangular housing which may include a rectangular metal frame (not shown) for supporting the various parts of the apparatus.

The apparatus comprises a sheet feed means 11, preferably a pair of rollers, a developing section 12, a diffusion transfer section 13, a wash section 14, a rinse section 15, a finishing section 16, a drier 17, and output rollers 18.

All these sections include conveyor rollers 20 and the exit ends of at least the developing section 12 and the finishing section 16 have sets of squeeze rollers 21 to remove excess liquid from the sheet material as it exits the respective section. Sets of squeeze roller 21 may also be used in the wash and rinse sections.

All the rollers 11, 20, 21, 18 and squeeze rollers are linked by a single drive shaft (not shown) to operate simultaneously to advance sheet material through the apparatus 10 from the feed means 11 to the output rollers 18.

An aluminium printing plate (not shown) as it passes through the apparatus 10, consumes the chemicals in the various sections 12, 15, 16, in a manner which directly relates to the area of the plate. The image on the plate generally involves about 10 % - 25 % of the area of the plate and therefore the correlation between chemical consumption and area of the plate 21 passing through the apparatus is good.

Now in use the developing liquid, rinsing liquid and finishing liquid may be automatically replenished, depending upon the surface area of processed rates.

The developing section 12, wash section 14, and finishing section 16 are all supplied with process chemicals in liquid form. For the sake of clarity only one section, the finishing section, will be described in detail, the basic supply system to all sections being substantially identical.

The finisher is supplied from a container or holding tank 31 and is removed through a conduit 32 by a pump 33 and delivered to a feed head 34 to the finisher section reservoir 24. The pump is preferably a volumetric displacement pump. The level of finisher in the reservoir 24 is monitored by a liquid level sensor 25 which is connected to a microprocessor control unit 36.

The pump 33 is an electrical pump connected to an electrical power supply 37 via a switch 38. The switch 38 is connected to the control unit 36, so that the control unit can monitor the length of time for which the pump 33 is operational. In order to accurately replenish the individual process sections with required amount of process liquid during the operation of the process apparatus, the delivery rate of the different pumps must be accurately known. This is achieved by accurately calibrating each pump every time that the respective reservoir is completely filled.

During the initial fill of the reservoir 24, at the factory and at the operating site, under known conditions, the control unit 36 measures the time taken for the pump 33 to fill the reservoir up to a predetermined level measured by the sensor 25. The control unit 36 stores the time period information and since the volume of liquid required to reach that level is known, the control unit calculates the flow rate of the pump and stores that information in its memory as a reference standard.

This flow rate is then used to control the pump 24 during subsequent operation of the pump to regenerate the finisher during operation of the apparatus.

The next time a complete refill of the reservoir 24 occurs, the time taken to refill the reservoir is again measured, and either the true period or the flow rate calibrated therefrom, is compared with the reference value. If the new value is within the predetermined difference band from the reference value than the new value becomes the reference standard for calibrating the pump. However, if the new value falls outside the predetermined difference band then an error alarm 39 or 40, preferably indicator lights, is activated.

The alarms 39 and 40 can be of at least two types, one alarm 39 may be connected to sensors on the pump 33 or other components and may illuminate to give an error signal relating to a pump or other component failure, and the other alarm 38 illuminating to indicate an error in operator procedure. The alarms can be in the form of a panel of warning lights.

The pumps need not necessarily be volumetric pumps such as piston-type or membrane pumps, but may also be centrifugal pumps.

## Claims

1. A method of calibrating the delivery of liquid by a pump into a reservoir of a photographic development apparatus, said method comprising measuring the time taken to fill the reservoir through the pump to a predetermined level under standard conditions, storing said information or information derived therefrom in a memory, and using said information or information derived therefrom as a reference standard for subsequent controlled operations of the pump.

2. A method as claimed in claim 1, characterised in that the liquid is delivered to the reservoir through a volumetric displacement pump which is connected directly into a container of process liquid.

3. A method of refilling an empty liquid reservoir on a photographic development apparatus said apparatus having a pump calibrated as claimed in claim1 or claim 2, said method comprising measuring the time taken to refill said reservoir and comparing said information or information derived therefrom with the reference information, and if the difference between the reference information and the subsequent information falls within a predetermined difference band from the reference standard, substituting the newly measured information of the previous measured standard for subsequent controlled operations of the pump.

4. A method as claimed in claim 3, characterised in that if said difference between the reference information and the subsequent information falls outside said predetermined difference band then an alarm means is operated.

5. A method as claimed in claim 4 characterised in that said alarm means can signal a component failure and an operator procedure failure.

6. Apparatus for processing photographic material which includes at least one liquid reservoir (24) which in use is filled with liquid, a pump (33) for delivering liquid to the reservoir, a level sensor (25) for determining when the liquid in the reservoir has reached a predetermined level, timer means which measures the time period needed to fill said reservoir to said predetermined level, processor means (36) which calculates the pump flow rate from the measured time period and stores aid measured information as a standard reference and uses the information to control the operation of the pump for further delivery of liquid to the reservoir.

7. Apparatus as claimed in claim 6, characterised in that the processor means (36) is operable to measure the flow rate of the pump on subsequent refill operations and can substitute the new measurement or information therefrom as the standard reference provided that the new measurement is within a predetermined difference band of the old measurement.

8. Apparatus as claimed in claim 7, characterised in that the apparatus further includes an alarm means (39, 40) which is activated by said new measurement falling outside of the predetermined difference band.

9. Apparatus as claimed in claim 4, characterised in that the pump (33) is an electrically powered volumetric pump.

10. Apparatus as claimed in claim 8 or claim 9, characterised in that the apparatus further comprises a plurality of sensors each sensing different apparatus conditions, and the alarm means comprises a plurality of error indicators each of which can relate to a particular type of fault in the processing system, or a fault in the operator procedure.
